Europäisches Patentamt

European Patent Office

Office européen des brevets

(11) Veröffentlichungsnummer: **0 363 590**
**A2**

## (12) EUROPÄISCHE PATENTANMELDUNG

(21) Anmeldenummer: 89114508.8

(22) Anmeldetag: 05.08.89

(51) Int. Cl.⁵: **H05K 3/10**

(30) Priorität: 11.10.88 DE 3834479

(43) Veröffentlichungstag der Anmeldung:
**18.04.90 Patentblatt 90/16**

(84) Benannte Vertragsstaaten:
**AT BE CH DE ES FR GB IT LI NL SE**

(71) Anmelder: **GERBR. SCHMID GMBH & CO.**
**Robert-Bosch-Strasse**
**D-7290 Freudenstadt(DE)**

(72) Erfinder: **Schmid, Dieter C.**
**Am Schäferstich 19**
**D-7290 Freudenstadt(DE)**

(74) Vertreter: **Hoeger, Stellrecht & Partner**
**Uhlandstrasse 14 c**
**D-7000 Stuttgart 1(DE)**

(54) **Vorrichtung und Verfahren zum Belichten von auf Trägern aufgebrachten lichtempfindlichen Schichten.**

(57) Um bei einer Vorrichtung zum Belichten von auf Trägern aufgebrachten lichtempfindlichen Schichten, insbesondere von auf elektrischen Leiterplatten angeordneten Fotolackschichten, mit einer Belichtungskammer mit mindestens einer Lichtquelle und mit einem die auf die Fotolackschicht beim Belichtungsvorgang zu übertragende Bildinformation enthaltenden Bildinformationsträger eine kostengünstigere Übertragung der Bildinformation auf die mit lichtempfindlichen Schichten beschichteten Träger zu ermöglichen, wird vorgeschlagen, daß der Bildinformationsträger eine Vielzahl diskreter Elemente umfaßt, welche durch ein Signal einer Schaltvorrichtung einzeln und unabhängig voneinander ansteuerbar und reversibel von einem ersten in einen zweiten Zustand überführbar sind, und daß die Elemente im ersten Zustand eine Belichtung der jeweils entsprechenden Flächenteile der lichtempfindlichen Schichten ermöglichen und im zweiten Zustand eine Belichtung verhindern.

FIG.1

## Vorrichtung und Verfahren zum Belichten von auf Trägern aufgebrachten lichtempfindlichen Schichten

Die Erfindung betrifft eine Vorrichtung zum Belichten von auf Trägern aufgebrachten lichtempfindlichen Schichten, insbesondere von auf elektrischen Leiterplatten angeordneten Fotolackschichten, mit einer Belichtungskammer mit mindestens einer Lichtquelle und mit einem die auf die Fotolackschicht beim Belichtungsvorgang zu übertragende Bildinformation enthaltenden Bildinformationsträger.

Die bisher bekanntgewordenen Belichtungsvorrichtungen setzen voraus, daß die auf die Leiterplatte zu übertragende Bildinformation in Form eines Films vorliegt, der exakt ausgerichtet auf die Leiterplatte aufgelegt werden kann. Bei der Filmherstellung muß auf eine sehr exakte Maßhaltigkeit und Detailtreue geachtet werden, da dies Voraussetzung ist, daß die Leiterbahnenmuster von Ober- und Unterseite einer Leiterplatte zueinander passen. Das Problem potenziert sich bei der Herstellung von Multi-Layer-Platten, bei der mehrere dünne elektrische Leiterplatten übereinander angeordnet werden und bei denen die Leiterbahnenbilder aller einzelnen Schichten exakt zueinander passen müssen, um eine elektrisch funktionsfähige Mehrschichtplatte zu erhalten.

Die Probleme bei den bisherigen Belichtungsvorrichtungen ergeben sich im wesentlichen aus der Verwendung des Films und dessen Herstellung, die zeitaufwendig und teuer ist. Bei der Lagerung der Filme dürfen keine größeren Temperatur- und Feuchtigkeitsschwankungen auftreten, da hierdurch ein Verziehen der Filme verursacht werden kann. Ein weiteres Problem ist auch die Alterung des Filmmaterials und die Abnutzung des Films durch Gebrauch, was immer wieder die erneute Herstellung des Films als Maske notwendig macht.

Bei Leiterplatten, die auf ihrer Ober- und Unterseite eine Fotolackschicht aufweisen, auf die eine Bildinformation einer Filmmaske zu übertragen ist, ist eine sehr genaue Justierung und Planlage von Film und Trägermaterial notwendig. Häufig wird, um ein exaktes Aufliegen des Films auf der Leiterplatte zu gewährleisten, ein Vakuum angelegt.

In der neueren Entwicklung der Leiterplattentechnik geht der Trend, insbesondere bei großen, komplizierten und damit auch in der Herstellung sehr teuren Leiterplatten, hin zu Kleinserien, damit bei einer Änderung des Schaltungsentwurfes in der Produktion auf die neue Schaltung und die Verwendung neuer elektronischer Bausteine umgestellt werden kann, ohne daß veraltete Leiterplatten ausgemustert werden müssen.

Demgegenüber stellt sich die Erfindung die Aufgabe, eine Belichtungsvorrichtung vorzuschlagen, bei der insbesondere im Hinblick auf die Kleinserienfertigung eine weniger zeitaufwendige und damit kostengünstigere Übertragung von Bildinformation auf mit lichtempfindlichen Schichten beschichtete Träger möglich ist.

Diese Aufgabe wird bei einer Vorrichtung der eingangs beschriebenen Art erfindungsgemäß dadurch gelöst, daß der Bildinformationsträger eine Vielzahl diskreter Elemente umfaßt, welche durch ein Signal einer Schaltvorrichtung einzeln und unabhängig voneinander ansteuerbar und reversibel von einem ersten in einen zweiten Zustand überführbar sind, und daß die Elemente im ersten Zustand eine Belichtung der korrespondierenden Flächenteile der lichtempfindlichen Schicht ermöglichen und im zweiten Zustand eine Belichtung verhindern.

Der Bildinformationsträger kann beispielsweise eine Matrix von Lichtquellen,wie Leuchtdioden, insbesondere Laserdioden, umfassen. Diese bilden die einzelnen Elemente des Bildinformationsträgers. Lichtquelle und Bildinformationsträger bilden hier eine Einheit.

In einer anderen Ausgestaltung der Erfindung ist der Bildinformationsträger als eine zwischen Lichtquelle und Träger anzuordnende Maske mit einer Vielzahl diskreter Maskenelemente ausgebildet. Die Maskenelemente sind hierbei im ersten Zustand für das zur Belichtung verwendete Licht transparent und in dem zweiten Zustand im wesentlichen undurchlässig.

Beide Ausführungsformen realisieren das Prinzip, den bisher verwendeten Film als Informationsträger im Belichtungsprozeß durch einen Informationsträger zu ersetzen, dessen Information austauschbar ist.

Im folgenden wird die Erfindung hauptsächlich an Hand der die Maske umfassenden Ausführungsform diskutiert. Selbstverständlich sind diese Ausführungen auch auf eine Matrix aus einzeln ansteuerbaren Lichtquellen übertragbar, für die in diesen Ausgestaltungen der Vorrichtung ebenfalls Schutz begehrt wird.

Die Maske oder allgemein der Bildinformationsträger kann aus mehreren Teilen zusammengesetzt sein, die jeweils mehrere Elemente zusammenfassen. Damit läßt sich eine Kostenreduzierung bei der Herstellung der Vorrichtung erzielen.

Auch ist es möglich, zur Erhöhung der Auflösung mehrere Masken im Strahlengang hintereinander anzuordnen oder aber die Maske im μm-Bereich oszillieren zu lassen, so daß die von den einzelnen Maskenelementen erzeugten Bilder auf der fotoempfindlichen Schicht leicht gegeneinander verschoben sind. Hierdurch läßt sich in einfacher Weise eine Qualitätsverbesserung bei dem auf die lichtempfindliche Schicht übertragenen Bild erreichen.

Mit den Maskenelementen sind im wesentlichen durchgängige, d.h. nicht unterbrochene transparente und lichtundurchlässige Bereiche darstellbar.

Bei der erfindungsgemäßen Vorrichtung ist damit die Verwendung von Filmen und dem gesamten Verfahren der Übertragung der Bildinformation, die beim Schaltungsentwurf erhalten wurde, über die Vorlage (beispielsweise Dia) auf den Film ausgeschaltet und die Bildinformation wird direkt in der Maske, die bei der Belichtung verwendet wird, erzeugt. Da die Bildinformation in der Maske austauschbar ist, wird mit ein und derselben Maske die Übertragung einer Vielzahl von Bildinformationen auf einen beschichteten Träger möglich. Damit entfällt die Lagerung und Archivierung der temperatur- und feuchtigkeitsempfindlichen Filme, das Alterungsproblem der Filme ist beseitigt, ebenso das Problem der Abnutzung der Filme durch Gebrauch, da das Bild bei jedem Belichtungsvorgang neu aufgebaut werden kann. Maßhaltigkeit muß nur mehr für die eine Maske gefordert werden und nicht mehr für eine Vielzahl zu verwendender Filme oder Filmvorlagen.

Von der Kostenseite her ist die Herstellung von Einzelstücken der Leiterplatten bezüglich der Übertragung der Bildinformation beim Belichtungsvorgang nicht mehr teurer als bei Großserien, da nicht mehr die Maske als solche ausgewechselt werden muß, sondern nur die Maske mit einer anderen Bildinformation versorgt werden muß.

Die Maske kann zudem als stabile, exakt maßhaltige Platte ausgeführt werden, mit der die Justierung gegenüber der Leiterplatte bzw. bei der gleichzeitigen Belichtung der Ober- und Unterseite einer Leiterplatte auch gegenüber der notwendigen zweiten Maske einfach und wesentlich exakter durchgeführt wer den kann. Dieser Vorteil ist insbesondere bei den immer kleiner werdenden Abmessungen der Leiterbahnen bzw. den Abständen zwischen den Leiterbahnen von besonderer Bedeutung.

Die bei der erfindungsgemäßen Vorrichtung zu verwendende Maske wird vorzugsweise eine Flüssigkristallzellenmatrix umfassen, wobei ein Maskenelement durch eine oder mehrere Zellen dieser Matrix gebildet wird. Die Größe der einzelnen Flüssigkristallzellen bestimmt somit die Auflösung und damit die Detailtreue der Maske bei der Abbildung der auf die Leiterplatte zu übertragenden Bildinformation. Eine sehr gute Detailtreue ist beispielsweise schon mit ca. 10 x 10 Zellen pro mm² zu erreichen. Die Flüssigkristallzellenmatrix ist durch elektrische Signale einer Treiberschaltung ansteuerbar, was einen schnellen Austausch der in der Maske enthaltenden Bildinformation ermöglicht. Die zeitliche Verzögerung zwischen einem korrigierten bzw. neu entwickelten Schaltungsentwurf und der Produktion der entsprechenden Leiterplatte kann somit auf ein Minimum reduziert werden, da nur eine Umwandlung der beim Schaltungsentwurf erhaltenen Bildinformation in entsprechende Treibersignale für die Flüssigkristallzellenmatrix und deren Übermittlung notwendig ist. Damit ist bei der Leiterplattenherstellung eine extreme Flexibilität und Aktualität möglich und von den Herstellungskosten bezüglich des Belichtungsvorganges unterscheidet sich die Herstellung einer Einzelplatte nicht mehr von der Großserienproduktion.

Neben den Flüssigkristallzellen sind selbstverständlich auch andere optische Informationsträger, die anders als auf elektrischem Wege angesteuert werden können, beispielsweise löschbare optische Speicherzellen, denkbar. Die Flüssigkristallzellenmatrix empfiehlt sich derzeit wegen ihrer einfachen Bedienungsweise und ihrer ausgereiften Technologie.

Die Maske kann von ihren Abmessungen her einmal so ausgebildet sein, daß sie zu einem bestimmten Zeitpunkt die vollständige, auf die Schicht zu übertragende Information enthält. Die Maske sollte dabei so groß sein wie die größte in der Vorrichtung zu verarbeitende Leiterplatte. In diesem Fall ist dann die bevorzugte 1:1 Abbildung der Bildinformation auf der Trägeroberfläche möglich. Die Belichtung bei dieser Vorrichtung wird dann bei feststehender Maske und feststehendem Träger durchgeführt, was die Justierung zwischen Maske und Träger besonders vereinfacht.

Diese Vorrichtung, bei der die Maske die gesamte Information zu einem bestimmten Zeitpunkt enthält, bedingt jedoch, daß mit der Lichtquelle der Belichtungsvorrichtung eine gleichmäßige Ausleuchtung des gesamten Maskenfeldes erzielbar ist, wobei, wie auch in den bereits bekannten Belichtungsvorrichtungen, die Verwendung parallelen Lichts von großer Bedeutung ist. Deshalb wird sich diese Ausbildung der Maske vor allem für Belichtungsvorrichtungen für die Großserienproduktion oder die Herstellung großer Stückzahlen eignen, wo dieser Aufwand bezüglich der Belichtungskammer wirtschaftlich vertretbar ist.

Insbesondere bei kleineren Belichtungsvorrichtungen und solchen, die kostengünstiger in der Anschaffung sein sollen, wird die Maske vorzugsweise zu einem Zeitpunkt nur einen Teil der zu übertragenden Information enthalten, wobei hier dann vorgesehen ist, daß die Maske und der Träger relativ zueinander bewegbar sind, wobei die Bildinformation der Maske entsprechend der Relativbewegung von Maske und Träger austauschbar ist. Die Maske weist bei dieser Ausführungsform dann vorzugsweise Abmessungen auf, die in einer Dimension des Trägers die gesamte Information enthält, so daß ein einmaliges Überfahren von Maske und Träger zur Übertragung der gesamten Bildinformation auf die lichtempfindliche Schicht ausreicht; hier muß nur eine relativ kleine Fläche gleichmäßig und mit parallelem Licht ausgeleuchtet werden. Außerdem ist die mit Informationen zu versorgende Fläche der Maske kleiner, so daß bei Verwendung von Flüssigkristallzellenmatrizen (oder auch Leucht diodenmatrizen) eine wesentlich weniger umfangreiche Treiberschaltung vonnöten ist. Es muß hier nur sichergestellt werden, daß nach einem Verschieben von Maske und Träger gegeneinander eine entsprechend der Verschiebung modifizierte Bildinformation in der Maske enthalten ist.

Die genannten Vereinfachungen, die für diesen Typ von Belichtungsvorrichtung erzielt werden, schlagen sich natürlich in dem Herstellungspreis für eine solche Belichtungsvorrichtung nieder, so daß mit dieser Art von Belichtungsvorrichtungen äußerst kostengünstige Belichtungsvorrichtungen zur Verfügung gestellt werden, die zudem sehr wartungsfreundlich und unproblematisch zu bedienen sind.

Im Extremfall kann die Maske, die zu einem Zeitpunkt nur einen Teil der zu übertragenden Information enthält, aus einer einzelnen Maskenelementzeile bestehen, die die Bildinformation lediglich in einer Dimension des Trägers enthält. Die konstruktive Aufgabe der Relativbewegung von Maske und Träger gegeneinander läßt sich bei diesen Belichtungsvorrichtungen prinzipiell auf zwei Arten lösen:

Zum einen können die Maske und die Lichtquelle in der Belichtungskammer ortsfest angeordnet sein, wobei dann der Träger mittels einer Transportvorrichtung gegenüber der Maske und der Lichtquelle verschiebbar sein muß.

Alternativ hierzu kann auch der Träger in der Belichtungskammer während dem Belichtungsprozeß ortsfest angeordnet sein, während sich dann die Maske, gegebenenfalls zusammen mit der Lichtquelle, über die Trägeroberfläche hinweg bewegt.

Im ersten Falle wird vorzugsweise die Bildinformation in der Maske synchron mit der Verschiebung des Trägers ausgetauscht bzw. die Trägerverschiebung wird synchron zum Wechsel der Bildinformation in der Maske ausgeführt. Bei der alternativen Lösung, bei der der Träger ortsfest in der Belichtungskammer angeordnet wird und die Maske sich über die Oberfläche des Trägers bewegt, wird man vorzugsweise die Bewegung der Maske mit dem Austausch der Bildinformation synchronisieren. Um bei dieser Vorrichtung ebenfalls zu einer möglichst kostengünstigen konstruktiven Lösung zu kommen, wird man die Lichtquelle vorzugsweise wiederum so auslegen, daß nur der Bereich der Maske ausgeleuchtet wird, wobei dann die Lichtquelle die gleiche Bewegung wie die Maske ausführen muß. Vorzugsweise wird hierbei die Maske und die Lichtquelle von einer gemeinsamen Halterung getragen, so daß die Lichtquelle zur Maske nur einmal bei der Herstellung bzw. beim Austauschen und Erneuern der Lichtquelle justiert werden muß.

Selbstverständlich eignet sich die erfindungsgemäße Vorrichtung auch dafür, die Oberseite und Unterseite des Trägers in einem Arbeitsablauf zu belichten. Hierfür ist es notwendig, daß die Vorrichtung eine zweite Belichtungskammer mit einer zweiten Maske umfaßt. Gegebenenfalls können die beiden Belichtungskammern mit einer gemeinsamen Lichtquelle betrieben werden. Normalerweise wird man jedoch,um die optischen Vorrichtungen möglichst einfach zu halten, auf zwei getrennte Lichtquellen, jeweils eine für jede Belichtungskammer, zurückgreifen.

Bei einer bevorzugten Ausführungsform sind die Belichtungskammern spiegelbildlich zur Trägerposition beim Belichtungsvorgang angeordnet, so daß die an Ober- und Unterseite des Trägers vorhandenen lichtempfindlichen Schichten gleichzeitig belichtbar sind. Dieses Gerät läßt die Belichtung der Ober- und Unterseite des Trägers in einem Arbeitsgang bei sehr kompakter Bauweise der Vorrichtung zu.

Alternativ kann auch vorgesehen sein, zwei Belichtungskammern in Reihe anzuordnen, wobei dann der Träger zwischen den beiden Belichtungskammern gewendet werden muß. Auch hier ist ein kontinuierliches Durchlaufen der Träger durch die Belichtungsvorrichtung möglich. Bei einer vereinfachten Vorrichtung kann auch vorgesehen sein, zur Belichtung der zweiten Oberfläche des Trägers den Träger nach dem ersten Belichtungsvorgang zu wenden und erneut der Belichtungskammer zuzuführen, so daß jetzt die bereits belichtete Seite auf der der Maske abgewandten Seite zu liegen kommt. Mit einer solchen Vorrichtung sind zwar nicht dieselben Stückzahlen pro Zeiteinheit herzustellen wie mit den zuvor genannten, jedoch ist nur eine einzige Belichtungskammer und die damit verbundene ausgefeilte Technik notwendig.

Die in den Belichtungskammern verwendete Lichtquelle ist beispielsweise ein UV-Quarzbrenner oder ein Halogenstrahler und wird vorzugsweise eine gepulste Lichtquelle sein, z.B. eine gepulste Lampe, Blitzlampe oder gepulstes Laserlicht.

Die Lichtquelle wird weiterhin vorzugsweise eine optische Vorrichtung zur Erzeugung von im wesentlichen parallelem Licht umfassen, so daß optisch eine sehr getreue Abbildung der Bildinformation der Maske auf die lichtempfindliche Schicht erreicht wird. Dies ist insbesondere dann von Bedeutung, wenn die Leiterbahnen bzw. die Zwischenabstände zwischen den Leiterbahnen sehr klein bemessen sind und vor allem dann, wenn zwischen der Bildinformation der Maske und der fotoempfindlichen Schicht ein gewisser Zwischenabstand eingehalten werden muß.

Alternativ hierzu ist es möglich, ein Lichtleitersystem einzusetzen, das die Belichtung der einzelnen Maskenelemente über einzelne Lichtleiterfasern oder -faserbündel bewerkstelligt.

Um insbesondere die Wärmebelastung der Maske durch das von der Lichtquelle einfallende Licht zu verringern, kann zwischen der Lichtquelle und der Maske zur Selektion eines bestimmten Wellenlängenbereiches, auf den die fotoempfindliche Schicht anspricht, ein Lichtfilter und/oder eine kühlbare, insbesondere wasserkühlbare, Zwischenplatte angeordnet sein.

Der durch das Lichtfilter selektierte Spektralbereich wird vorzugsweise den Absorptionseigenschaften des zu belichtenden Fotolacks angepaßt.

Eine Verringerung der Wärmebelastung der Maske ist auch damit zu erreichen, daß eine gepulste Lichtquelle verwendet wird. Diese wird vorzugsweise synchron zum Wechsel der Bildinformation der Maske betätigbar sein. Vor allem bei den Belichtungsvorrichtungen gemäß der Erfindung, die für Kleinserien oder gar Einzelstückproduktionen vorgesehen sind, hat es sich als vorteilhaft erwiesen, wenn die Schaltvorrichtung einen Datenspeicher für die Bildinformation umfaßt. Hierbei kann dann der Datenspeicher die Bildinformation für mehrere Leiterplattentypen umfassen, die dann bei Bedarf an die Maske weitergegeben werden. Damit ist es möglich, eine automatisch arbeitende Vorrichtung herzustellen, wobei dann die Vorrichtung zusätzlich einen Detektor zur Erkennung des zu verarbeitenden Trägertyps und/oder der Trägeroberfläche umfassen muß. Die Schaltvorrichtung kann dabei so ausgelegt sein, daß sie automatisch in Abhängigkeit des Detektorsignals die entsprechende Bildinformation aus dem Datenspeicher abruft und gegebenenfalls aufbereitet an die Maske übermittelt. Bei einer besonders bevorzugten Ausführungsform wird die Belichtungsvorrichtung eine Schaltvorrichtung mit einer Datenverarbeitungsanlage umfassen, in die gegebenenfalls der Datenspeicher integriert ist.

Vorzugsweise wird in diesem Fall aus der Datenverarbeitungsanlage eine aufbereitete Bildinformation für die Maske abrufbar sein.

Die Verknüpfung von Belichtungsvorrichtung und Datenverarbeitungsanlage bietet die Möglichkeit, daß die beispielsweise an einem CAD-Arbeitsplatz erstellte Bildinformation beim Schaltungsentwurf on line an die Datenverarbeitungsanlage der Belichtungsvorrichtung übermittelt wird und von dort direkt auf die Maske, gegebenenfalls in aufbereiteter Form, übertragen wird.

Damit kann gewährleistet werden, daß jede Schaltungsänderung, die für die Herstellung freigegeben ist, sofort bei der Produktion von Leiterplatten berücksichtigt wird, und dem Entwickler steht nach beendetem Schaltungsentwurf in kürzester Zeit eine fertig belichtete Leiterplatte zur Verfügung.

Im Falle der Integration einer Datenverarbeitungsanlage in die Belichtungsvorrichtung ist es zweckmäßig, die Signale des Detektors zur Erkennung des zu verarbeitenden Trägertyps und/oder der zu verarbeitenden Trägeroberfläche zuzuführen. Damit kann man die Datenverarbeitungsanlage für die Steuerung des Betriebs der Belichtungsvorrichtung einsetzen. Die zu verarbeitenden Trägerplatten brauchen dann nur noch in einem Stapel in der Eingangsstation der Belichtungsvorrichtung abgelegt werden, von dem sie in die Belichtungsvorrichtung transportiert werden, und der Belichtungsvorgang mit samt der Auswahl der korrekten Bildinformation läuft dann vollkommen automatisch ab, indem die Datenverarbeitungsanlage selbständig der Maske in Abhängigkeit des zu verarbeitenden Trägertyps die vorbestimmte Bildinformation zuführt. Die in diesem Fall notwendige Codierung der Träger bzw. von deren Oberflächen stellt gegenüber dem durch die Automatisierung erhaltenen Zeitgewinn keinen relevanten Kostenfaktor dar.

Die Erfindung betrifft des weiteren ein Verfahren zum Belichten von auf Trägern aufgebrachten lichtempfindlichen Schichten, insbesondere von auf elektrischen Leiterplatten angeordneten Fotolackschichten, wobei eine eine Bildinformation enthaltende Maske bezüglich des Trägers ausgerichtet wird und wobei die in der Maske enthaltene Bildinformation mittels einer Lichtquelle in einem Belichtungsvorgang auf die lichtempfindliche Schicht übertragen wird. Gegenüber diesem und bereits zu Beginn beschriebenen Stand der Technik stellt sich die Erfindung die Aufgabe, das Verfahren zum Belichten dieser Träger zu vereinfachen und die bei der bisherigen Methode vorhandenen Fehlerquellen zu beseitigen.

Diese Aufgabe wird bei dem zuvor beschriebenen Verfahren erfindungsgemäß dadurch gelöst, daß eine Maske verwendet wird, die eine Vielzahl an Maskenelementen umfaßt, welche in einem ersten Zustand für das bei der Belichtung verwendete Licht transparent und in einem zweiten Zustand im wesentlichen undurchlässig sind, wobei die Bildinformation in der Maske durch Signale einer Schaltvorrichtung erzeugt wird, durch die jedes der einzelnen Maskenelemente einzeln und unabhängig von den anderen Elementen angesteuert und von dem ersten in den zweiten Zustand bzw. umgekehrt überführt wird. Gegenüber dem Stand der Technik, der Filme als Masken bei der Belichtung der Schichten verwendet, wird also der Schritt der Herstellung eines Filmes bei dem erfindungsgemäßen Verfahren ausgeschaltet und damit auch die dabei bestehenden vielfältigen Fehlerquellen. Statt der Herstellung eines Dias von dem fertigen Schaltungsentwurf und der nachfolgenden Herstellung von Filmmasken für die Belichtung der Leiterplatten wird die Bildinformation direkt auf die Maske für jeden Belichtungsvorgang übertragen und auch direkt in dem identischen Format erzeugt. Hierdurch entfallen insbesondere Verzerrungen bei der Vergrößerung bzw. Verkleinerung oder allgemein optischen Abbildung des Schaltungsentwurfes, bis dieser auf die lichtempfindliche Schicht übertragen wird, und des weiteren die durch die Eigenschaften des Filmmaterials (Temperatur- und Feuchtigkeitsempfindlichkeit) bedingten Ungenauigkeiten in der Reproduktion. Als Masken können beliebige Matrizen aus Maskenelementen verwendet werden, die als wieder löschbare "Bildinformations"-Träger fungieren können. Verwendbar sind demnach optisch beschreibbare und wieder löschbare Medien oder aber auch elektrisch ansteuerbare Zellenmatrizen. Hierbei wird bevorzugt eine Flüssigkristallzellenmatrix verwendet, deren Technologie bekannt und erprobt ist.

Mit dem erfindungsgemäßen Verfahren kann alternativ entweder, wie dies auch bei den früheren Verfahren praktiziert wird, die gesamte Bildinformation auf den ganzen Träger gleichzeitig über tragen werden oder aber in Abweichung von der bisherigen Praxis schrittweise auf den Träger übertragen werden, wobei eine Auswechslung der Bildinformation in der Maske eine Relativbewegung der Maske gegenüber dem Träger oder umgekehrt entspricht und wobei selbstverständlich die restlichen Teilbereiche des Trägers gegen Lichteinfall abgedeckt werden.

Vorzugsweise wird im zweiten Fall der Austausch der Bildinformation in der Maske und die Relativbewegung synchron erfolgen.

Dabei kann die Maske zusammen mit der Lichtquelle bewegt werden, was den Vorteil hat, daß die Lichtquelle nur so ausgelegt sein muß, daß sie gerade den kleinen Bereich der Maske gleichmäßig und vorzugsweise mit parallelem Licht ausleuchtet.

Vorteilhaft ist die Verwendung einer gepulsten Lichtquelle insbesondere dann, wenn die Relativbewegung von Maske gegenüber Träger schrittweise und nicht kontinuierlich ausgeführt wird. Dabei läßt sich dann das Pulsen der Lichtquelle mit der schrittweisen relativen Verschiebung des Trägers gegenüber der Maske bzw. der Maske gegenüber dem Träger und dem Austausch der Bildinformation in der Maske synchronisieren.

Insgesamt kürzere Belichtungszeiten lassen sich dann erreichen, wenn auch im Falle, daß der Bildinformationsträger die gesamte Information umfassen kann, der Schichtträger beim Belichtungsvorgang gegenüber der Maske bewegt wird und der Bildgehalt der Maske synchron zur Bewegung verändert wird, so daß die Teilflächen der fotoempfindlichen Schicht während dem Belichtungsvorgang mit einer konstanten optischen Abbildung beaufschlagt werden.

Wegen des Umfanges der Bildinformation empfiehlt es sich, zu deren Aufbereitung und Bereitstellung eine Datenverarbeitungsanlage zu verwenden. Da bei der heutigen Leiterplattentechnik fast durchgängig auf der Ober- und Unterseite beschichtete Träger verwendet werden, ist es vorteilhaft, diese in einem Arbeitsgang zu belichten. Dies kann dann gleichzeitig geschehen, wenn spiegelbildlich zur Trägerposition beim Belichtungsvorgang zwei Belichtungskammern vorhanden sind. Dies empfiehlt sich insbesondere bei hohen Durchsätzen.

Andererseits kann die Ober- und Unterseite des Trägers auch zeit lich nacheinander belichtet werden, wobei der Träger vor der zweiten Belichtung gewendet und der Belichtungskammer zugeführt werden kann. Eine solche Verfahrensführung ermöglicht den Einsatz von sehr kostengünstig und kompakt aufgebauten Belichtungsvorrichtungen, wie sie vor allem bei der Herstellung kleinerer Stückzahlen sinnvoll sind.

Das Verfahren läßt sich insbesondere mit den zuvor beschriebenen Vorrichtungen in einfacher Weise automatisieren, wobei dann die Träger automatisch einem Vorrat entnommen und kontinuierlich der Belichtungsvorrichtung zugeführt werden. Hierbei kann dann vorgesehen sein, das die Träger und/oder die jeweiligen Trägeroberflächen zuvor codiert werden und daß die Codierung vor der Belichtung abgetastet wird, wobei dann der Maske die der abgetasteten Codierung entsprechende Bildinformation beim Belichtungsvorgang zugeführt wird. Auch in diesem Zusammenhang empfiehlt sich der Einsatz einer Datenverarbeitungsanlage, die das Verfahren und die Vorrichtung in unterschiedlichen Einsatzzwecken sehr flexibel macht.

Das Verfahren wurde bislang im wesentlichen unter Bezugnahme auf eine Maske als Informationsträger beschrieben. Selbstverständlich gelten die vorstehenden Darlegungen sinngemäß auch für die Variante der Erfindung, gemäß der als Bildinformationsträger eine aus Einzelelementen zusammengesetzte oder gerasterte Lichtquelle, beispielsweise eine Leuchtdiodenmatrix, verwendet wird.

In der vorstehenden Beschreibung der Erfindung wurden die mit lichtempfindlichen Schichten beschichteten Träger im wesentlichen unter dem Aspekt von elektrischen Leiterplatten, die mit auflaminierten Fotolackschichten versehen sind, diskutiert. An dieser Stelle sei darauf hingewiesen, daß, unabhängig von dem Verwendungszweck der Träger, selbstverständlich für jeden denkbaren Träger von fotoempfindlichen Schichten die Vorrichtung und das Verfahren verwendbar bzw. anwendbar sind. Insbesondere eignet sich die erfindungsgemäße Vorrichtung und das erfindungsgemäße Verfahren auch zur Herstellung von Filmen, wie sie dann in den in dem jeweiligen Herstellungsbetrieb noch vorhandenen konventionellen Belichtungsvorrichtungen als Maske verwendet werden. Auch hier ist die Vorrichtung und das Verfahren noch mit Vorteil einzusetzen, da die Filme quasi im Direktkopierverfahren im Maßstab 1:1, d.h. ohne Vergrößerung oder Verkleinerung, als Kontaktabzug hergestellt werden. Somit läßt sich die erfindungsgemäße Vorrichtung und das damit zu betreibende Verfahren auch in Kombination mit bereits an Ort und Stelle vorhandenen herkömmlichen Belichtungsvorrichtungen verwenden, wobei die erfindungsgemäße Vorrichtung sowohl für die Herstellung von Leiterplatten als auch für die Herstellung von Filmen für die noch konventionell zu betreibenden Belichtungsgeräte verwendbar ist. Auch hier kann direkt von der nur digital vorhandenen CAD-Bildinformation ein Film erzeugt werden, ohne daß zunächst eine Papiervorlage oder ähnliches benötigt wird. Damit läßt sich auch noch mit dem Betrieb der erfindungsgemäßen Vorrichtung mit bereits bestehenden konventionellen Einrichtungen ein Rationalisierungseffekt erzeugen.

Diese und weitere Vorteile der Erfindung werden im folgenden an Hand der Zeichnung noch näher erläutert. Es zeigen im einzelnen:

Figur 1 Eine schematische perspektivische Ansicht einer erfindungsgemäßen Belichtungsvorrichtung;

Figur 2 eine Detailansicht von Maske und Träger;

Figuren 3 und 4 Schnittansichten durch erfindungsgemäße Belichtungsvorrichtungen.

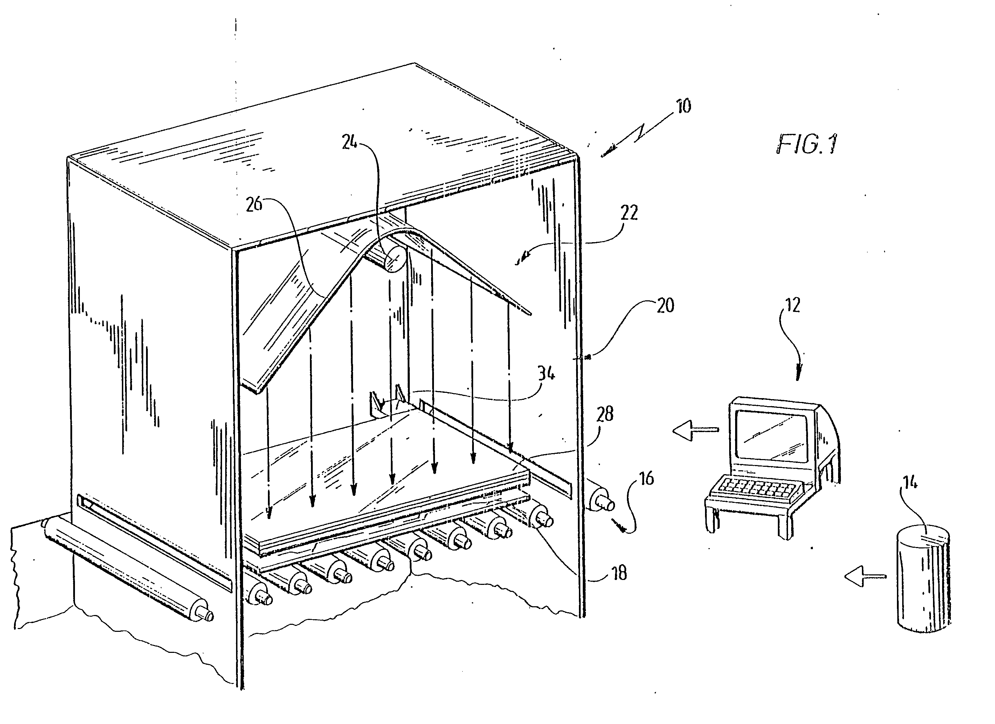

Figur 1 zeigt schematisch eine insgesamt mit dem Bezugszeichen 10 gekennzeichnete Belichtungsvorrichtung, die über eine Datenverarbeitungsanlage 12 gesteuert werden kann. Die an eine Belichtungsvorrichtung 10 zu übertragende Bildinformation bezieht die Datenverarbeitungsanlage 12 aus einem Datenspeicher 14.

Die Belichtungsvorrichtung 10 weist eine Transportvorrichtung 16 für plattenförmige Träger 18 auf, die diese durch eine Belichtungskammer 20 hindurchführt. In der Belichtungskammer 20 ist eine Lichtquelle 22 angeordnet, die im wesentlichen aus einer Lampe 24 und einem Reflektor 26 aufgebaut ist. Die Lampe 24 ist bezüglich des Reflektors 26 so angeordnet, daß im wesentlichen paralleles Licht in Richtung zur Trägerplatte 18 erzeugt wird.

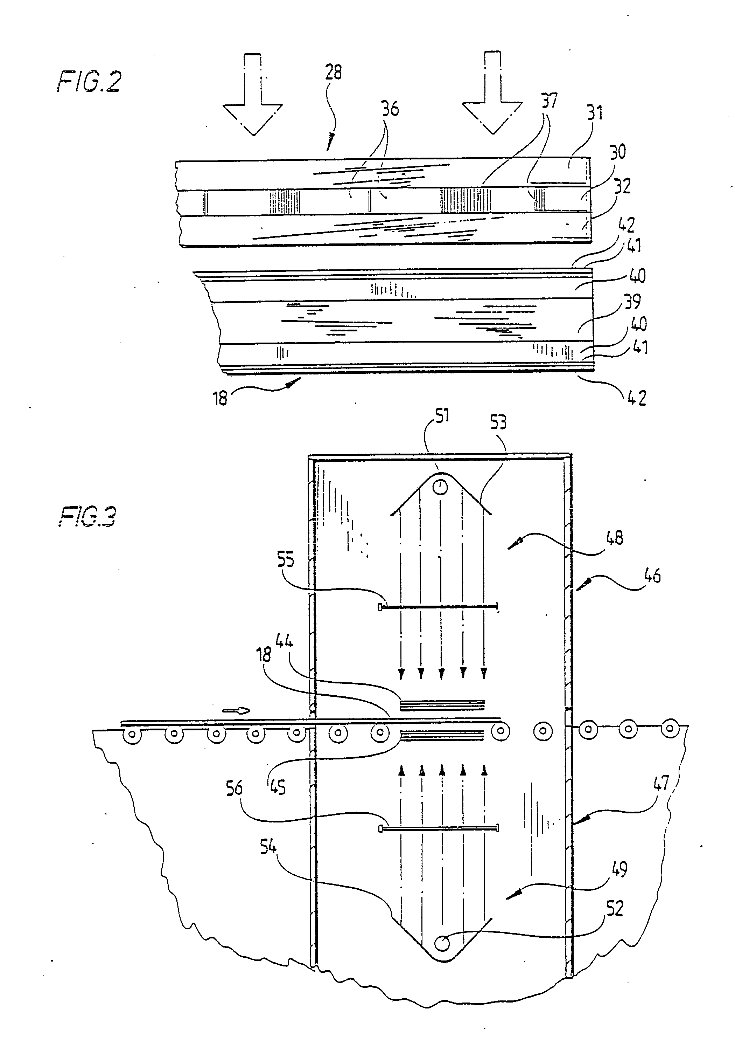

Zwischen Lichtquelle 22 und Trägerplatte 18 ist, direkt benachbart zur Trägerplatte 18, eine Maske 28 angeordnet, die im wesentlichen aus einer Flüssigkristallzellenmatrix 30 besteht, die zwischen zwei Glasplatten 31, 32 angeordnet ist (siehe insbesondere Figur 2).

Die Maske 28 ist in dem in Figur 1 gezeigten Ausführungsbeispiel so groß, daß sie zu einem Zeitpunkt die gesamte Bildinformation, die auf die Trägerplatte übertragen werden soll, darstellen und enthalten kann. Die Maske 28 ist in der Belichtungskammer 20 von einer justierbaren Halterung 34 parallel zur Transportebene der Träger 18 gehalten, und zwar in der Weise, daß zwischen den Trägern 18 und der Maske 28 nur ein minimaler Spalt verbleibt. Es kann auch vorgesehen sein, daß die Maske 28 während dem Transportvorgang der Leiterplatte 18 angehoben wird und für den Belichtungsvorgang selbst auf die Trägerplatte 18 abgesenkt wird.

Die von der Maske 28 wiedergegebene Bildinformation wird über die Datenverarbeitungsanlage 12 von dem Datenspeicher 14 bezogen, gegebenenfalls aufgearbeitet und an eine entsprechende Treiberschaltung für die Flüssigkristall-Zellenmatrix 30 weitergeleitet.

Aus Figur 2 ist der genauere Aufbau der Maske 28 sowie der elektrischen Leiterplatte, die hier als Träger fungiert, ersichtlich. Die Abbildung ist der besseren Übersichtlichkeit halber nicht maßstabsgetreu ausgeführt. Insbesondere können sich große Abweichungen bezüglich der Verhältnisse der einzelnen Schichtdicken zueinander ergeben.

Wie bereits zuvor erwähnt, baut sich die Maske 28 im wesentlichen aus zwei parallelen Glasplatten und einer dazwischen angeordneten Flüssigkristallzellenmatrix 30 auf, bei der Bereiche 36 transparent und Bereiche 37 für das auf die Matrix von oben (strichpunktierte Pfeile) auffallende Licht undurchlässig sind. Diese einzelnen Bereiche können von einer in den Zeichnungen nicht dargestellten Treiberschaltung von einem transparenten in einen undurchlässigen Zustand und umgekehrt überführt werden, so daß sich die Bildinformation der Maske beliebig aufbauen und austauschen läßt.

Die darunter in Figur 2 angeordnete Trägerplatte 18 weist einen im wesentlichen aus einem Kunstharz bestehenden Kern 39 auf, der beidseitig mit Kupferschichten 40 beschichtet ist. Auf den Kupferschichten 40 ist jeweils eine Fotolackschicht 41 und eine darüber liegende transparente Schutzschicht 42 angeordnet.

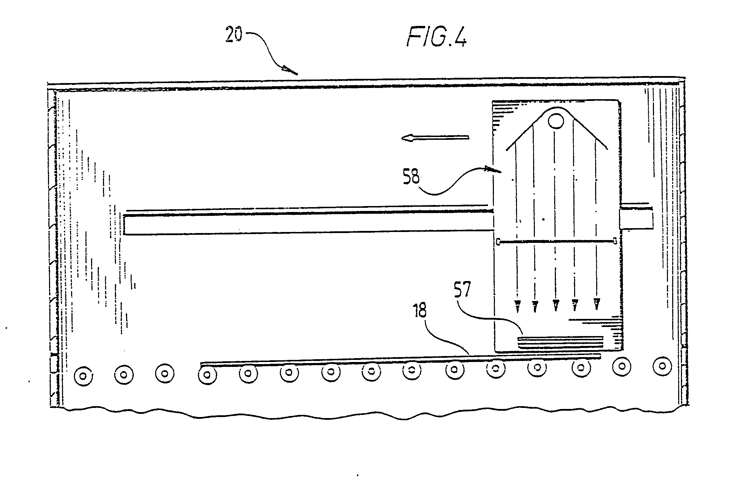

In Figur 3 ist eine Belichtungsvorrichtung gemäß der Erfindung gezeigt, die nach einem alternativen Prinzip zu dem in Figur 1 gezeigten arbeitet. Außerdem zeigt Figur 3 eine Vorrichtung, bei der zwei Belichtungskammern 46, 47 spiegelbildlich zur Transportebene der Trägerplatten angeordnet sind und jeweils eine Maske 44 bzw. 45 umfassen.

Der vom Prinzip her wichtigste Unterschied zwischen der in Figur 3 und Figur 1 gezeigten Ausführungsformen ist der, daß bei der Ausführungsform der Figur 3 die Masken 44, 45 nur einen Teil der gesamten auf den Träger zu übertragenden Bildinformation zu einem Zeitpunkt beinhalten können und daß diese in Form einer Leiste quer zur Transportrichtung der Trägerplatten 18 in den Belichtungskammern 46, 47 angeordnet sind. Die Flüs sigkristallzellenmatrix der Masken 44, 45 ist allerdings so groß gehalten, daß die Bildinformation über die gesamte Breite der Trägerplatte 18 zu einem Zeitpunkt abbildbar ist. Die Breite der Flüssigkristallzellenmatrix parallel zur Transportrichtung kann unterschiedlich sein und hängt von dem Aufwand, den man bezüglich der Ausleuchtung der Maske und der elektrischen Ansteuerung der Maske betreiben möchte, ab. Bei der in Figur 3 gezeigten Maske ist nicht nur eine Maskenelementzeile vorhanden, sondern die Masken 44 und 45 umfassen einen größeren Teil der gesamten Bildinformation. Die Verkleinerung der Maske gegenüber der in Figur 1 gezeigten Ausbildungsform hat den Vorteil, daß die Lichtquelle bzw. die in Figur 3 gezeigten Lichtquellen 48, 49 wesentlich kleiner dimensioniert werden können als die Lichtquelle 22 in Figur 1. Die Lichtquellen 48, 49 umfassen entsprechend der Lichtquelle in Figur 1 Lampen 51, 52, die so bezüglich der Reflektoren 53 und 54 ausgerichtet sind, daß im wesentlichen paralleles Licht in Richtung zu den Masken 44 bzw. 45 ausgesendet wird. Das Licht wird in dem in Figur 3 gezeigten Beispiel jeweils durch Lichtfilter 55, 56 spektral selektiert, so daß nur der Wellenlängenbereich, für den die Fotolackschicht des Trägers 18 empfindlich ist, auf die Masken 44, 45 trifft. Hiermit wird gewährleistet, daß die Wärmebelastung, die gerade bei Flüssigkristallzellen möglichst niedrig gehalten werden muß, um eine stabile Hell-Dunkel-Tastung bzw. Transparent-/Undurchlässigtastung zu erreichen, auf ein Minimum beschränkt wird. Je nach Spektralverteilung der Lichtquelle und je nach Absorptionsverhalten der Fotolackschicht wird ein Kantenfilter oder ein Bandpaßfilter verwendet.

Die Lampen 51 und 52 wie auch die Lampe 24 in der Figur 1 können als Lampen, die ein Dauerlicht aussenden, ausgebildet sein oder aber als gepulste Lampen betrieben werden. Anstelle dieser Lampen lassen sich Blitzlichtröhren einsetzen oder aber das erforderliche Licht von einer Laserlichtquelle zuführen.

Bei der in Figur 3 gezeigten Ausführungsform sind die Masken 44, 45 sowie die Lichtquellen 48, 49 ortsfest angeordnet, während die Trägerplatte 18 synchron zu dem Wechsel der Bildinformation in den Masken 44, 45 durch die beiden Belichtungskammern 46, 47 transportiert wird.

Die in Figur 4 gezeigte Ausführungsform der Erfindung arbeitet ebenfalls mit einer Maske, die nur einen Teil der Bildinformation zu einem Zeitpunkt enthalten kann. Im Gegensatz jedoch zu dem in Figur 3 gezeigten Ausführungsbeispiel ist bei der in Figur 4 gezeigten Vorrichtung die Trägerplatte 18 während dem Belichtungsvorgang ortsfest angeordnet, während die Maske 57 zusammen mit der Lichtquelle 58 die Oberfläche des feststehenden Trägers überfährt. Bei dieser Ausführungsform ist es vorteilhaft, die Lichtquelle und die Maske in einem Gehäuse bzw. in einer Halterung unterzubringen, so daß eine einmalige Justierung der Lichtquelle 58 gegenüber der Maske 57 eine gleichmäßige Ausleuchtung des Maskenfeldes sicherstellt. Die Lichtquelle beinhaltet, wie bereits bei den in Figur 3 gezeigten Ausführungsformen, neben der Lampe und dem Reflektor ein Lichtfilter.

Die Bewegung von Maske gegenüber Träger bei den Ausführungsformen in den Figuren 3 und 4 kann entweder kontinuierlich oder aber schrittweise erfolgen, wobei bei einem kontinuierlichen Austausch der Bildinformation in der Maske und einem kontinuierlichen Überfahren der Maske bzw. des Trägers eine kontinuierliche Belichtung erfolgen kann. Im Falle des schrittweisen Überfahrens wird nach der abschnittsweisen Relativbewegung der Bildinhalt in der Maske ausgetauscht und danach ein (Teil-)Belichtungsvorgang eingeleitet. Nach diesem teilweisen Belichtungsvorgang erfolgt wiederum eine schrittweise Relativbewegung von Träger gegenüber der Maske bzw. umgekehrt, ein Austausch der Bildinformation in der Maske und ein erneutes Belichten. Insbesondere dieses schrittweise Verschieben von Träger gegenüber Maske bzw. umgekehrt eignet sich in Kombination mit einer gepulsten Lichtquelle, insbesondere mit Blitzlichtlampen, wodurch man sich für den Zeitraum zwischen zwei Belichtungsphasen das Abdecken der Trägerplatte 18 ersparen kann.

Umfaßt die leistenförmige Maske 44, 45 oder 57 nur eine einzelne Maskenelementzeile, so kann man eine quasi kontinuierliche Belichtung der Trägerplatte 18 durchführen, indem man mit einem schrittweisen Vorrücken der Trägerplatte oder aber der Maskenelementzeile um die Breite eines Maskenelementes, das beispielsweise ca. 1/10 mm beträgt, mit dem Vorrücken jeweils die Bildinformation in der Maskenelementzeile austauschen und danach auf die Blitzlichtlampe einen Impuls geben.

Je nach Leistung der Blitzlichtlampe und der auszuleuchtenden Maskenfläche reicht ein einmaliges oder aber erst ein mehrmaliges Pulsen der Lampen für eine ausreichende Belichtung der Fotolackschicht aus.

Bei einem vollautomatischen Betrieb der erfindungsgemäßen Belichtungsvorrichtung ist zusätzlich noch ein Vorratslager an Trägerplatten vorzusehen, aus dem die Vorrichtung automatisch bei Bedarf die nächste Trägerplatte entnimmt. Hierbei ist es für die Flexibilität des Produktionsprozesses förderlich, wenn die Trägerplatten eine Codierung tragen, die eine Identifizierung des Trägertyps und/oder der zu belichtenden Trägeroberfläche erlaubt. Damit können über einen Detektor die jeweils zu belichtenden Trägeroberflächen an die angeschlossene Datenverarbeitungsanlage gemeldet werden, die dann die entsprechenden Bildinformationen aus dem Datenspeicher 14 abruft und diese entweder insgesamt, wie bei der in Figur 1 abgebildeten Belichtungsvorrichtung, oder aber schrittweise an die Maske 28 bzw. 44, 45 oder 57 abgibt. Über eine Kopplung von Steuerrechner der Belichtungsvorrichtung mit der EDV, wie sie im Entwicklungslabor Verwendung findet, kann eine zeitliche Verzögerung zwischen einer Korrektur einer Schaltung bzw. einem Neuentwurf einer Schaltung und dem Einspeisen dieses Schaltungsentwurfes in die Produktion praktisch auf Null gesenkt werden, da quasi im gleichen Augenblick, in dem die Freigabe der neuen Schaltung erfolgt ist, diese als Datenmaterial für die Datenverarbeitungsanlage 12 der Belichtungsvorrichtung zur Verfügung stehen kann.

**Ansprüche**

1. Vorrichtung zum Belichten von auf Trägern aufgebrachten lichtempfindlichen Schichten, insbesondere von auf elektrischen Leiterplatten angeordneten Fotolackschichten, mit einer Belichtungskammer mit mindestens einer Lichtquelle und mit einem die auf die Fotolackschicht beim Belichtungsvorgang zu übertragende Bildinformaticn enthaltenden Bildinformationsträger, **dadurch gekennzeichnet,**
daß der Bildinformationsträger eine Vielzahl diskreter Elemente umfaßt, welche durch ein Signal einer Schaltvorrichtung einzeln und unabhängig voneinander ansteuerbar und reversibel von einem ersten in einen zweiten Zustand überführbar sind, und daß die Elemente im ersten Zustand eine Belichtung der jeweils entsprechenden Flächenteile der lichtempfindlichen Schicht ermöglichen und im zweiten Zustand eine Belichtung verhindern.

2. Vorrichtung nach Anspruch 1, dadurch gekennzeichnet, daß der Bildinformationsträger eine zwischen Lichtquelle und Träger anzuordnende Maske mit einer Vielzahl diskreter Maskenelemente ist und daß die Maskenelemente im ersten Zustand für das zur Belichtung verwendete Licht transparent und in dem zweiten Zustand im wesentlichen undurchlässig sind.

3. Vorrichtung nach Anspruch 2, dadurch gekennzeichnet, daß die Maske (28; 44, 45; 57) eine Flüssigkristallzellenmatrix (30) umfaßt, wobei ein Maskenelement eine oder mehrere Zellen der Matrix umfaßt.

4. Vorrichtung nach einem oder mehreren der Ansprüche 1 bis 3, dadurch gekennzeichnet, daß der Bildinformationsträger so ausgebildet ist, daß mit ihm zu einem Zeitpunkt die vollständige, auf die Schicht zu übertragende Information abbildbar ist.

5. Vorrichtung nach einem oder mehreren der Ansprüche 1 bis 3, dadurch gekennzeichnet, daß der Bildinformationsträger zu einem Zeitpunkt einen Teil der zu übertragenden Information enthält und daß der Bildinformationsträger und der Träger (18) der lichtempfindlichen Schicht relativ zueinander bewegbar sind, wobei die Bildinformation des Bildinformationsträgers entsprechend der Relativbewegung austauschbar ist.

6. Vorrichtung nach Anspruch 5, dadurch gekennzeichnet, daß der Bildinformationsträger nur eine einzelne Elementzeile umfaßt, die die Bildformation entsprechend der Breite des Trägers (18) enthält.

7. Vorrichtung nach Anspruch 5 oder 6, dadurch gekennzeichnet, daß die Maske (44, 45; 57) und die Lichtquelle (48, 49; 58) in der Belichtungskammer (46, 47) ortsfest angeordnet sind und daß der Träger (18) mittels einer Transportvorrichtung (16) gegenüber der Maske und der Lichtquelle verschiebbar ist.

8. Vorrichtung nach Anspruch 7, dadurch gekennzeichnet, daß der Träger (18) synchron zum Wechsel der Bildinformation verschiebbar ist oder daß die Bildinformation synchron zum Verschieben des Trägers (18) auswechselbar ist.

9. Vorrichtung nach Anspruch 5 oder 6, dadurch gekennzeichnet, daß der Träger (18) in der Belichtungskammer (20) während des Belichtungsvorgangs ortsfest angeordnet ist und daß die Maske (57) gegebenenfalls zusammen mit der Lichtquelle (58) über den Träger (18) hinweg bewegbar ist.

10. Vorrichtung nach Anspruch 9, dadurch gekennzeichnet, daß die Bildinformation der Maske (57) synchron mit der Bewegung relativ zum Träger (18) austauschbar ist.

11. Vorrichtung nach einem oder mehreren der voranstehenden Ansprüche, dadurch gekennzeichnet, daß die Vorrichtung (10) eine zweite Belichtungskammer (47) mit einer zweiten Maske (45) umfaßt.

12. Vorrichtung nach Anspruch 11, dadurch gekennzeichnet, daß die Belichtungskammern (46, 47) spiegelbildlich zur Trägerposition beim Belichtungsvorgang angeordnet sind, so daß an Ober- und Unterseite des Trägers (18) vorhandene lichtempfindliche Schichten (41) gleichzeitig belichtbar sind.

13. Vorrichtung nach einem oder mehreren der voranstehenden Ansprüche, dadurch gekennzeichnet, daß die Lichtquelle (22; 48, 49; 58) eine gepulste Lichtquelle umfaßt.

14. Vorrichtung nach einem oder mehreren der voranstehenden Ansprüche, dadurch gekennzeichnet, daß die Lichtquelle (22; 48, 49; 58) eine optische Vorrichtung (26; 53, 54) zur Erzeugung von im wesentlichen parallelem Licht umfaßt.

15. Vorrichtung nach einem oder mehreren der voranstehenden Ansprüche, dadurch gekennzeichnet, daß die Lichtquelle ein Lichtleitersystem umfaßt.

16. Vorrichtung nach einem oder mehreren der voranstehenden Ansprüche, dadurch gekennzeichnet, daß zwischen der Lichtquelle (48, 49; 58) und der Maske (44 bzw. 45 bzw. 57) zur Selektion eines bestimmten Wellenlängenbereiches ein Lichtfilter (55, 56) und/oder eine kühlbare, transparente Zwischenplatte angeordnet ist.

17. Vorrichtung nach einem oder mehreren der Ansprüche 13 bis 16, dadurch gekennzeichnet, daß die gepulste Lichtquelle synchron zum Wechsel der Bildinformation der Maske betätigbar ist.

18. Vorrichtung nach einem oder mehreren der voranstehenden Ansprüche, dadurch gekennzeichnet, daß der Maske in Abhängigkeit des zu verarbeitenden Trägertyps und/oder Trägeroberfläche eine vorbestimmte Bildinformation zuführbar ist.

19. Verfahren zum Belichten von auf Trägern aufgebrachten lichtempfindlichen Schichten, insbesondere von auf elektrischen Leiterplatten angeordneten Fotolackschichten, wobei ein eine Bildinformation enthaltender Bildinformationsträger bezüglich des Trägers ausgerichtet wird und wobei die Bildinformation mittels einer Lichtquelle in einem Belichtungsvorgang auf die lichtempfindliche Schicht übertragen wird, dadurch gekennzeichnet, daß ein Bildinformationsträger verwendet wird, der eine Vielzahl an Elementen umfaßt, welche durch ein Signal einer Schaltvorrichtung einzeln und unabhängig voneinander ansteuerbar und reversibel von einem ersten in einen zweiten Zustand überführbar sind, und daß die Elemente im ersten Zustand eine Belichtung der jeweils entsprechenden Flächenteile der lichtempfindlichen Schicht ermöglichen und im zweiten Zustand eine Belichtung verhindern.

20. Verfahren nach Anspruch 19, dadurch gekennzeichnet, daß als Bildinformationsträger eine zwischen Lichtquelle und Träger anzuordnende Maske mit einer Vielzahl diskreter Maskenelemente verwendet wird, wobei die Maskenelemente im ersten Zustand für das zur Belichtung verwendete Licht transparent und in dem zweiten Zustand im wesentlichen undurchlässig sind.

21. Verfahren nach Anspruch 20, dadurch gekennzeichnet, daß als Maske eine Flüssigkristallenmatrix verwendet wird.

22. Verfahren nach einem der Ansprüche 19 bis 21, dadurch gekennzeichnet, daß die Bildinformation auf den gesamten Träger gleichzeitig übertragen wird.

23. Verfahren nach einem der Ansprüche 19 bis 21, dadurch gekennzeichnet, daß die Bildinformation schrittweise auf den Träger übertragen wird, wobei einer Auswechslung der Bildinformation im Bildinformationsträger eine Relativbewegung gegenüber dem Träger oder umgekehrt entspricht und wobei die restlichen Teilbereiche des Trägers abgedeckt sind.

24. Verfahren nach Anspruch 23, dadurch gekennzeichnet, daß der Austausch der Bildinformation und die Relativbewegung synchron erfolgen.

25. Verfahren nach Anspruch 23 oder 24, dadurch gekennzeichnet, daß die Maske zusammen mit der Lichtquelle bewegt wird.

26. Verfahren nach einem oder mehreren der Ansprüche 19 bis 25, dadurch gekennzeichnet, daß als Lichtquelle eine gepulste Lichtquelle verwendet wird.

27. Verfahren nach Anspruch 26, dadurch gekennzeichnet, daß das Pulsen der Lichtquelle mit einem schrittweisen relativen Verschieben des Trägers gegenüber der Maske bzw. der Maske gegenüber dem Träger und dem Austausch der Bildinformation der Maske synchronisiert wird.

28. Verfahren nach einem oder mehreren der Ansprüche 19 bis 27, dadurch gekennzeichnet, daß zur Aufbereitung und Bereitstellung der Bildinformation eine Datenverarbeitungsanlage verwendet wird.

29. Verfahren nach einem oder mehreren der Ansprüche 19 bis 28, dadurch gekennzeichnet, daß die Ober- und Unterseite des Trägers gleichzeitig belichtet werden.

30. Verfahren nach einem oder mehreren der Ansprüche 19 bis 29, dadurch gekennzeichnet, daß das von der Lichtquelle kommende Licht vor dem Auftreffen auf die Maske spektral gefiltert wird.

31. Verfahren nach einem oder mehreren der Ansprüche 19 bis 30, dadurch gekennzeichnet, daß die Träger automatisch einem Vorrat entnommen und kontinuierlich der Belichtungsvorrichtung zugeführt werden.

32. Verfahren nach einem oder mehreren der Ansprüche 19 bis 31, dadurch gekennzeichnet, daß die Träger und/oder die Trägeroberflächen codiert werden, daß die Codierung vor der Belichtung abgetastet wird und daß der Maske die der abgetasteten Codierung entsprechende Bildinformation vor dem Belichtungsvorgang zugeführt wird.

EP 0 363 590 A2

FIG.1

Gebr.   Schmid   GmbH & Co. ,
Blatt 1     Robert - Bosch - Straße  34    ,   7290  Freudenstadt

FIG.2

FIG.3

Blatt 2

FIG.4

20

58

57

18